# EUROPEAN PATENT APPLICATION

(11) **EP 4 622 416 A1**
(43) Date of publication of application: **24.09.2025**
(21) Application number: 25161382.4
(22) Date of filing: 03.03.2025
(51) Int. Cl.: H10D 30/66, H10D 30/01, H10D 62/10, H10D 64/00

(54) **SUPERJUNCTION POWER SEMICONDUCTOR DEVICE HAVING AN IMPROVED EDGE TERMINATION**

(30) Priority: 18.03.2024 IT 202400005977
(71) Applicant: STMicroelectronics International N.V., 1228 Plan-les-Ouates, Geneva (CH)
(72) Inventor: SANTANGELO, Antonello, 95032 BELPASSO (CT) (IT); RENNA, Lucio, 95027 SAN GREGORIO DI CATANIA (CT) (IT); NGWAN, Voon Cheng, 732686 SINGAPORE (SG)
(74) Representative: Studio Torta S.p.A.

(57) **Abstract**

A superjunction power semiconductor device (1) having a die (20') of semiconductor material comprising a structural layer (27) with a first doping type having an active area (26) where active cells (5) are formed and an edge area (28) surrounding the active area (26) at the periphery of the die (20'). An edge termination arrangement (22) at the edge area (28) has a plurality of edge-termination trenches (30) extending through the structural layer (27) filled with a dielectric material and having respective doped layers (14) having a second doping type at sidewalls thereof. The edge termination arrangement (22) has electrical connection structures (34), to electrically connect together the respective doped layers (14) at the sidewalls of the edge-termination trenches (30).

## Description

### TECHNICAL FIELD

The present solution relates to a superjunction power semiconductor device having an improved edge termination.

### BACKGROUND

Superjunction power semiconductor devices, e.g. MOSFET devices, are based on the principle of charge balancing or charge compensation, according to which charge in a structural layer of a first conductivity or doping type (for example a n-type epitaxial layer) is compensated, or balanced, by doped columns or pillars formed in the same layer and having a second conductivity or doping type (in the example, having a p-type doping). This technology is advantageous, for example in terms of a trade-off achievable between a breakdown voltage and an on-state resistance of the power semiconductor devices.

However, manufacturing costs for this technology are quite high, since formation of the doped columns requires complex manufacturing steps, such as multiple steps of implantation and epitaxial growth, or complete filling (without voids) of deep trenches having high aspect ratios, for example up to 20(depth):1(width).

Moreover, like all power devices, an edge termination is required, in order to achieve desired breakdown voltage performances and proper design of the edge termination is not in general a straightforward process for these superjunction power semiconductor devices.

An architecture of a charge-balanced dual trench superjunction MOSFET device, which allows to overcome at least some of the above issues, has recently been proposed, see for example US 2023/0107611 A1.

Advantageously, manufacturing of this superjunction MOSFET device does not require multiple epitaxial processing steps, nor epitaxial filling of deep trenches, in order to form columnar charge balancing structures for MOSFET cells.

However, also this superjunction MOSFET device has to deal with the issue of providing an efficient edge termination, in particular considering that the charge-balancing structure of a last MOSFET cell may see a high voltage difference between the reference (ground) potential of respective body and source regions and the high voltage at the edge of the same device (corresponding to the drain-source voltage of the superjunction MOSFET device 1), that may cause an undesired distribution of the electrical field lines.

A known solution that has been proposed for the edge termination is that of providing a dielectric-filled deep and wide trench as a protection of the periphery of the active area of the device, with a field plate on top.

This technique is disclosed e.g. in Noblecourt, S. et al., Design optimisation of the deep trench termination for superjunction power devices, International Journal of microelectronics and computer science, Vol. 6 No. 4, 2015.

However, this solution has drawbacks in the difficulty of controlling the depth of this larger trench simultaneously to manufacturing of the charge balancing trenches in the active area; and also in the complexity of achieving a complete filling (without voids) of this last trench.

### SUMMARY

The present solution generally aims to overcome the limitations of known superjunction power devices, in particular concerning the issue of providing an efficient edge termination region.

According to the present solution, a superjunction power device is therefore provided, as defined in the attached claims.

### BRIEF DESCRIPTION OF THE FIGURES

For a better understanding of the present invention, a preferred embodiment thereof is now described, purely by way of non-limiting example and with reference to the attached drawings, wherein:
- Figure 1 shows a cross-section of a portion of a superjunction power device;
- Figure 2 shows a cross-section of a portion of a superjunction power device and a respective edge termination region, according to an aspect of the present solution;
- Figure 3 is a plot of a potential distribution in an edge area of the superjunction power device;
- Figures 4A-4K shows cross-sections of the power semiconductor device in consecutive steps of a manufacturing process, in relation to a first embodiment of an edge-termination arrangement;
- Figure 5 shows a plan view of an edge portion of the power semiconductor device of Figure 4K, in a possible embodiment;
- Figure 6A shows a plan view of an edge portion of the power semiconductor device of Figure 4K, in a further embodiment;
- Figure 6B shows a cross-section of the power semiconductor device of Figure 6A;
- Figures 7A-7K shows cross-sections of the power semiconductor device in consecutive steps of a manufacturing process, in relation to a second embodiment of the edge-termination arrangement;
- Figure 8 shows a plan view of an edge portion of the power semiconductor device of Figure 6K, according to a possible embodiment; and
- Figures 9A-9H shows cross-sections of the power semiconductor device in consecutive steps of a manufacturing process, in relation to a third embodiment of the edge-termination arrangement.

### DESCRIPTION OF EMBODIMENTS

As will be discussed in the following, an aspect of the present solution relates to an improved edge termination for a superjunction power semiconductor device, in particular a MOSFET device, including dielectric-filled trenches with doped sidewalls arranged in the periphery of an active area of the device. In particular, sidewalls of adjacent trenches are electrically connected and kept at a floating potential, so as to achieve a gradual distribution of the voltage potential in the edge area of the superjunction power semiconductor device and a proper confinement of the electrical field lines.

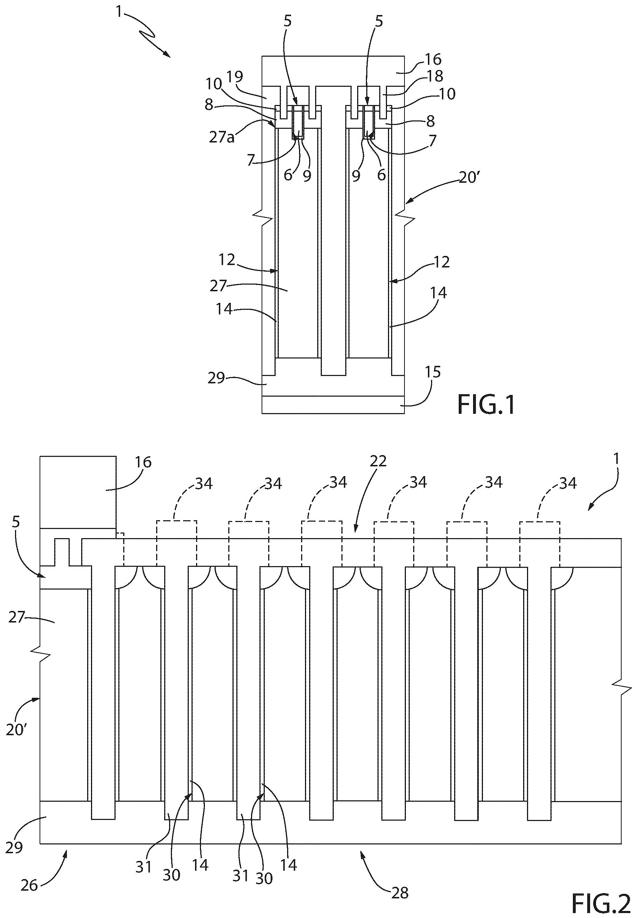

As shown in Figure 1, a superjunction power semiconductor device, in particular a MOSFET device, denoted in general with 1, comprises a die 20' of semiconductor material, for example silicon (or other semiconductor materials, such as silicon carbide), comprising a substrate 29 having a low thickness (roughly, 20-200 µm) and a first doping type with a high concentration, e.g. n⁺⁺ (for example, with doping concentration up to 4e¹⁶ cm⁻³).

An epitaxial layer 27 is formed on the substrate 29, having the first doping type and a lower concentration (e.g., n type) .

MOSFET cells 5 are formed at a top surface 27a of the epitaxial layer 27, opposite to the substrate 29. Each MOSFET cell 5, of the trench-gate type, comprises: a gate region 6, of doped polysilicon, arranged in a respective gate trench 7 formed though a superficial portion of the epitaxial layer 27; body regions 8, of a second doping type (p type) laterally surrounding the gate trench 7, separated from the same gate trench 7 by a thin dielectric layer 9; and source regions 10, of the first doping type (n type) arranged on the body regions 8, laterally with respect to the respective gate trench 7.

The power semiconductor device 1 further comprises a plurality of charge-balancing deep trenches 12, filled with dielectric, in particular with oxide, extending throughout the epitaxial layer 27 and reaching the underlying substrate 29. Each MOSFET cell 5 is arranged, in an active area of the MOSFET device, between adjacent pairs of charge-balancing deep trenches 12.

In particular, the power semiconductor device 1 comprises, at sidewalls of each charge-balancing deep trench 12, thin doped layers 14 having the second doping type (p type), for example with a width in the range of ten nano meters to two hundred of nano meters, aimed at compensating under depletion the epitaxial n-type charge and achieving a charge balancing. These thin doped layers 14 constitute p-doped pillars allowing a correspondent narrow and heavily doped n-type epitaxial drift region, improving tradeoff between the on-resistance and breakdown voltage (in general, the smaller the width, the better the performance in terms of the on-resistance).

The power semiconductor device 1 further comprises, at the back of the substrate 29, a drain contact layer 15; and, above the top surface 27a of the epitaxial layer 27 (that represents the drift region for the device), a source contact layer 16, which contacts both the body and source regions 8, 10 through contact elements (or "plugs") 18, extending vertically through a dielectric region 19, overlying the same top surface 27a, and traversing the source regions 10 reaching the body regions 8 (the source contact layer 16 being usually kept at a reference voltage potential, e.g. ground GND).

Figure 2 shows an improved edge-termination arrangement 22 of the power semiconductor device 1, according to an aspect of the present solution.

The edge-termination arrangement 22 is formed in an edge area 28 of the power semiconductor device 1, at the periphery of the die 20', which surrounds the active area, here denoted with 26, where the active cells 5 are formed.

Figure 2 shows only one of the active cells 5, the one closest to the edge area 28; in a manner not shown in the same Figure 2, the power semiconductor device 1 comprises, in the active area 26, a plurality of charge-balancing deep trenches formed in the epitaxial layer 27 and reaching the substrate 29 and including a dielectric filling region and thin doped layers at the sidewalls of the same trenches (as discussed for the above Figure 1).

According to an aspect of the present solution, the edge-termination arrangement 22 comprises a plurality of edge-termination deep trenches 30, arranged in the edge area 28 with a regular distribution, each edge-termination deep trench 30 traversing the epitaxial layer 27 and reaching the substrate 29 and comprising a dielectric filling region 31 and thin doped layers, again denoted with 14, at the sidewalls thereof.

The edge-termination arrangement 22 further comprises electrical connection structures 34 (shown schematically in Figure 2), which are configured to electrically connect together (i.e., to short) the thin doped layers 14 at the sidewalls of each of the edge-termination deep trenches 30. In particular, a first one of these electrical connection structure 34 (nearest to the active area 26) is connected to the source and body regions of the last active cell 5 in the same active area 26 and to the source contact layer 16 (so as to be at the reference or ground potential); all other electrical connection structures 34 are instead left floating (i.e. not being connected to any specific voltage potential).

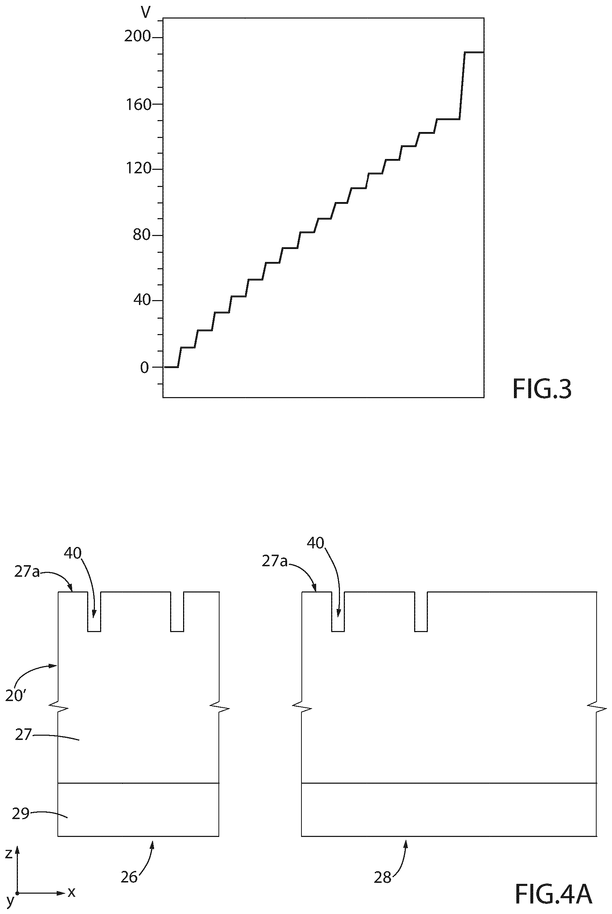

The resulting effect, as schematically shown in Figure 3, is a gradual shift of the electrical potential in the edge area 28 of the power semiconductor device 1 from the reference potential (GND, 0 V) to a drain-to-source voltage, e.g. at 180-190V (each increasing voltage step corresponding to one of the electrical connection structures 34).

In a manner not shown in the above Figure 2, the edge-termination deep trenches 30 have a ring conformation surrounding the active area 26 of the power semiconductor device 1, with increasing radius moving away from the same active area 26. Moreover, the electrical connection structures 34 may not be continuous along the ring of the respective edge-termination deep trench 30, instead being distributed regularly with a given separation distance along the same ring (as will be disclosed in more details in the following).

With reference first to Figure 4A, a first embodiment of a process for manufacturing the power semiconductor device 1 is now discussed, with particular reference to manufacturing of the edge-termination arrangement 22 in the edge area 28 (at a same time of manufacturing of the active cells 5 in the active area 26).

Figure 4A shows the substrate 29 and the epitaxial layer 27 of the power semiconductor device 1, both in the active area 26 and in the edge area 28 of the same power semiconductor device 1. In the following, unless otherwise specified, the steps that will be discussed are intended to be performed both in the active area 26 and in the edge area 28 of the same semiconductor device 1, at a same time.

A first step of the manufacturing process envisages formation of shallow trenches 40 starting from the top surface 27a of the epitaxial layer 27, having for example a width of 0,1 to 1 µm along a first axis x of a horizontal plane xy (parallel to the top surface 27a) and a depth of 0,5 to 2 µm in a vertical direction, along a vertical axis z orthogonal to the horizontal plane xy. In the active area 26, the shallow trenches 40 are designed to form gate trenches for the active cells 5 of the power semiconductor device 1.

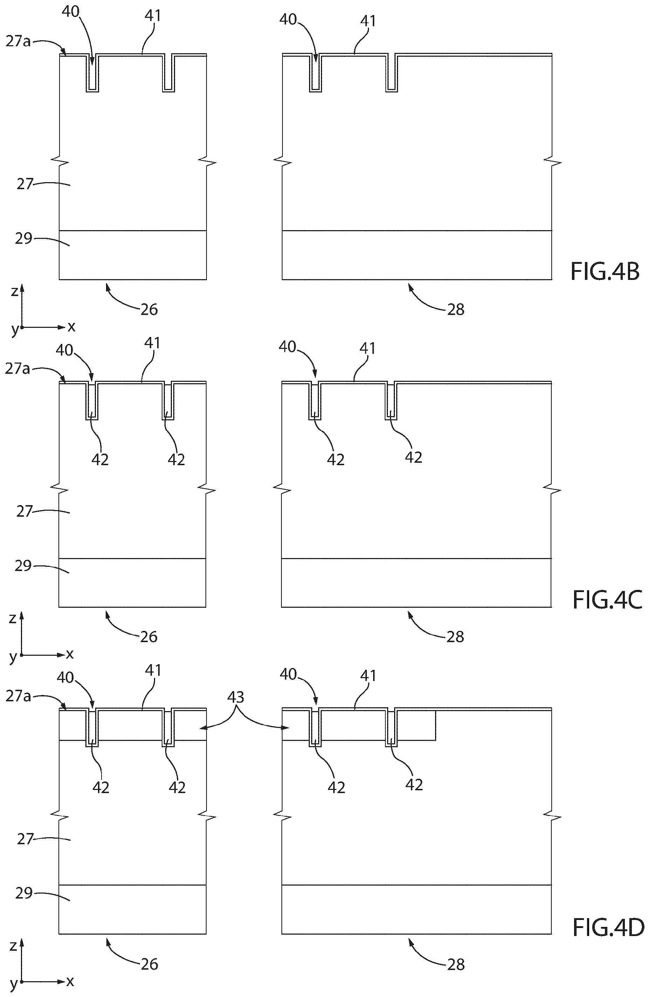

As shown in Figure 4B, a thin dielectric layer 41 is formed, e.g. by thermal oxidation, on the top surface 27a and in the shallow trenches 40 (coating lateral walls and a bottom thereof).

A polysilicon region 42 is then formed, Figure 4C, within the shallow trenches 40, in particular being separated from the epitaxial layer 27 by the dielectric layer 41.

As shown in Figure 4D, a doped layer 43 of a second doping type (p type) is formed in a surface portion of the epitaxial layer 27, at the top surface 27a thereof; in the active area 26, this doped layer 43 is designed to form body regions for the active cells 5 of the power semiconductor device 1.

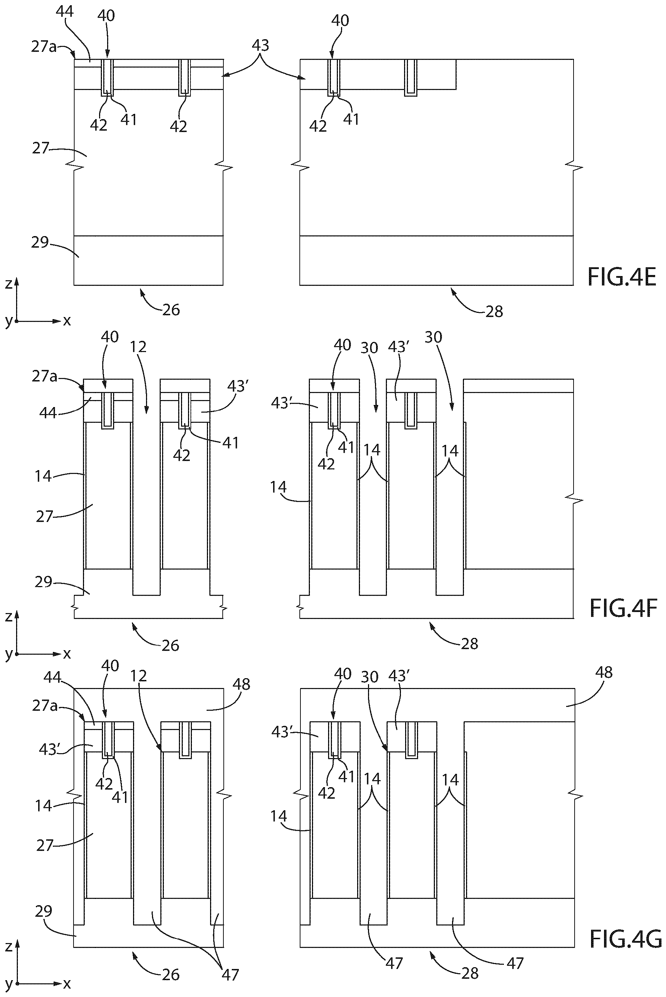

The manufacturing process then envisages, Figure 4E, removal of the thin dielectric layer 41 from the top surface 27a of the epitaxial layer 27 and then, only in the active area 26 of the power semiconductor device 20, a superficial doping for the formation of a superficial doped layer 44 having the first doping type (n type); in the active area 26, this superficial doped layer 44 is designed to form source regions for the active cells 5 of the power semiconductor device 1.

Afterwards, Figure 4F, deep trenches are etched through the epitaxial layer 27 and reaching the substrate 29, each of the deep trenches being formed between a respective pair of shallow trenches 40. In particular, these deep trenches are designed to form the plurality of charge-balancing deep trenches 12 in the active area 26 and the plurality of edge-termination deep trenches 30 in the edge area 28.

Subsequently, as shown in the same Figure 4F, sidewalls of the deep trenches are doped to form the thin doped layers, again denoted with 14, having the second doping type (p type). In particular, these thin doped layers 14 are contiguous to and in contact with doped regions 43' of the previously formed doped layer 43 (also having the second doping type).

The manufacturing process then continues, Figure 4G, with filling of the deep trenches 46 with a dielectric filling region 47, for example of silicon oxide. The same step also leads to formation of a dielectric layer 48 on the top surface 27a of the epitaxial layer 27.

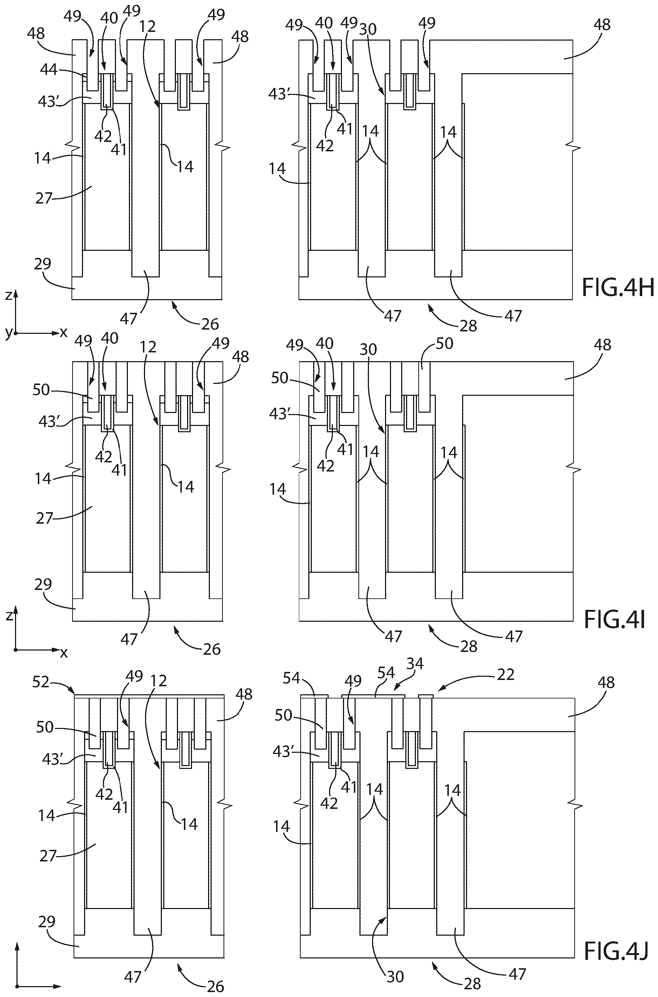

As shown in Figure 4H, contact openings 49 are then opened through the dielectric layer 48 and the underlying doped regions 43' (and also the superficial doped layer 44 in the active area 26). In particular, a pair of contact openings 49 are formed at the sides of each of the shallow trenches 40, at a certain distance of separation from the respective thin dielectric layer 41.

As shown in Figure 4I, the contact openings 49 are then filled with a conductive material, e.g. Tungsten, to form contacts (or "plugs") 50 within the same contact openings 49.

A thin barrier layer 52, of a conductive material, e.g. TiN, is then deposited on the dielectric layer 48, as shown in Figure 4J, contacting the contacts 50 from above.

The barrier layer 52 is continuous in the active area 26.

According to a particular aspect of the present solution, the same barrier layer 52 is patterned in the edge area 28 in order to define barrier portions 54, which are configured to electrically connect in pairs the thin doped layers 14 of respective edge-termination deep trenches 30. In particular, each barrier portion 54 contacts from above a pair of contacts 50 arranged at the sides of a respective edge-termination deep trench 30 and reaching the doped regions 43' of the doped layer 43; these barrier portions 54, together with the respective contacts 50 therefore define the above electrical connection structures 34 of the edge-termination arrangement 22.

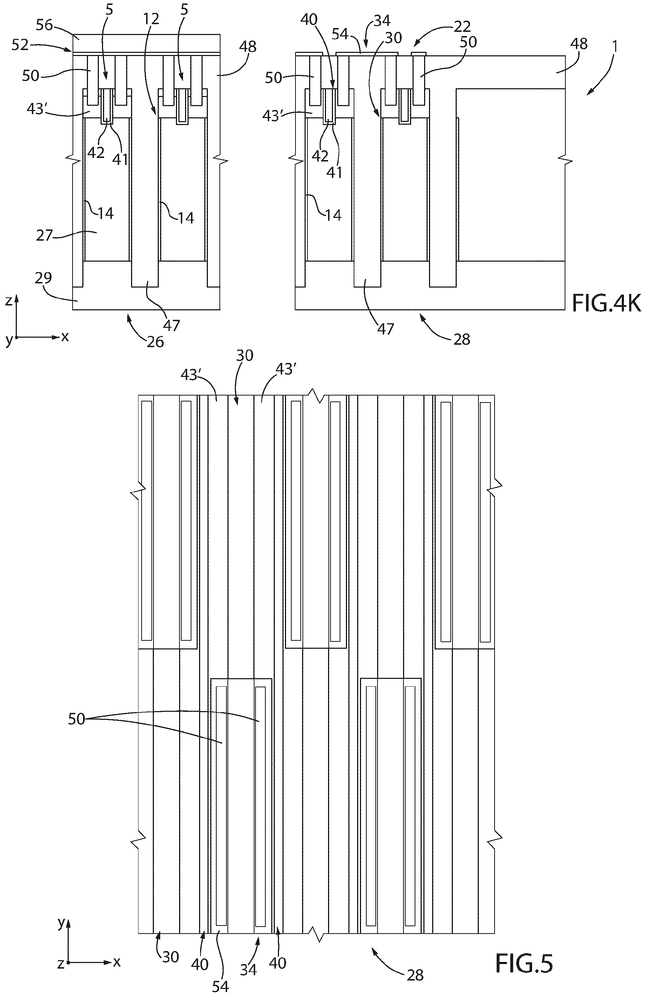

As shown in Figure 4K, the manufacturing process then continues with the formation of a thick top metal layer 56 on the barrier layer 52 in the sole active area 26, to define the source contact layer of the power semiconductor device 1.

As discussed above, in a possible embodiment of the edge-termination arrangement 22, the contact structures 34 are not continuous along the ring surrounding the active area 26.

In this respect, Figure 5 shows a top view of an edge portion of the power semiconductor device 1, where the electrical connection structures 34, instead of being continuous along an extension direction of the respective edge-termination deep trench 30, are distributed regularly with a given separation distance along the same extension direction (in Figure 5, along a second axis y of the horizontal plane xy).

In particular, the barrier portions 54 of the electrical connection structures 34 have a longitudinal extension that is much smaller than the respective edge-termination deep trench 30 and are arranged at a certain distance of separation along the extension direction of the same edge-termination deep trench 30 (in the example of Figure 5, the barrier portions 54 have a substantially rectangular shape in the horizontal plane xy).

Also the contacts 50 coupled to the respective barrier portions 54 have substantially the same longitudinal extension as the barrier portions 54.

Electrical continuity between the electrical connection structures 34 is assured in this case by the underlying doped regions 43', which are continuous along the ring surrounding the active area 26.

Moreover, in the embodiment shown, the barrier portions 54 associated with adjacent edge-termination deep trenches 30 are staggered in the above-defined extension direction, so that electrical connection structures 34 of adjacent edge-termination deep trenches 30 are not aligned (in Figure 5, along the first axis x of the horizontal plane xy). In the embodiment shown in the same Figure 5, barrier portions 54 of any given edge-termination deep trench 30 and of a next non-adjacent edge-termination deep trench 30 are instead aligned along the first axis x.

This embodiment of the electrical connection structures 34 may be particularly advantageous in all cases where a reduced width of the edge-termination deep trenches 30 may cause issues in the manufacturing of the contacts 50 laterally to the same trenches.

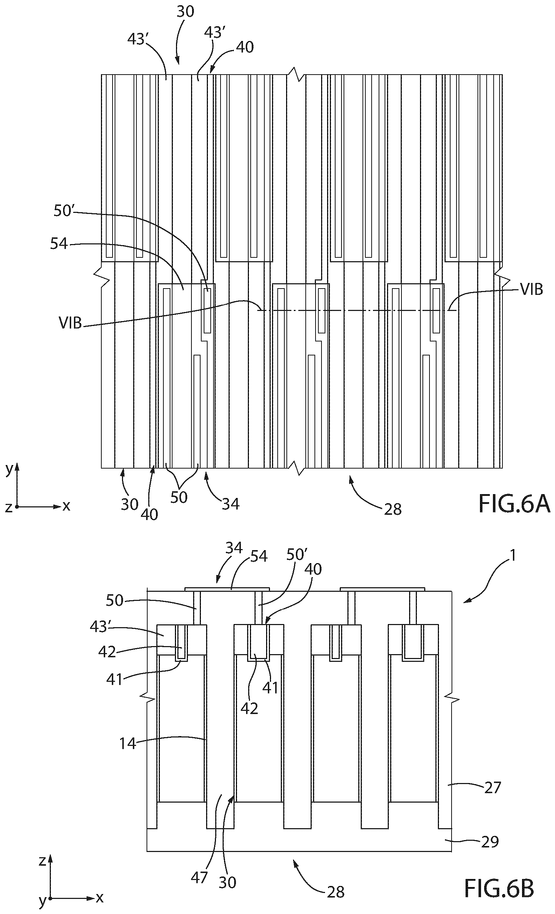

According to still a further embodiment of the present solution, which is now discussed with reference to Figure 6A and Figure 6B, the electrical connection structures 34 in the edge area 28 are moreover electrically connected (shorted) to the polysilicon regions 42 formed within the shallow trenches 40, so that also these polysilicon regions 42 are kept floating and at a same voltage potential as the corresponding electrical connection structures 34. This solution may be advantageous, allowing a further improvement in the control of the confinement of the electrical field lines in the edge area 28.

In this respect, further contacts, denoted with 50', are therefore formed through the dielectric layer 48 to reach the polysilicon regions 42 of respective underlying shallow trenches 40; and the barrier portions 54 of the electrical connection structures 34 are configured to electrically contact respective of these further contacts 50', in addition to the above defined contacts 50.

In particular, in the embodiment shown in Figures 6A and 6B, the further contacts 50' are arranged in a localized manner at a corner region of the respective barrier portions 54. As shown in the same Figures 6A and 6B, a localized enlargement of the shallow trenches 40 may be provided in the same corner region, in order to accommodate the further contacts 50'.

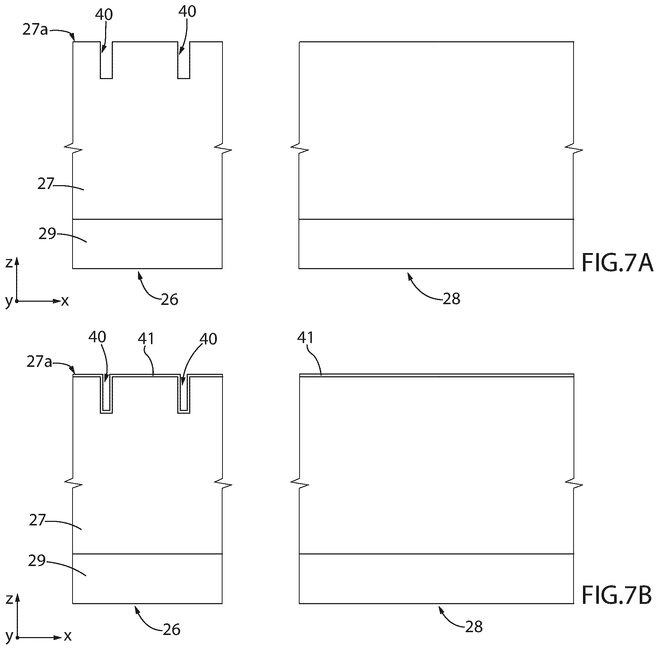

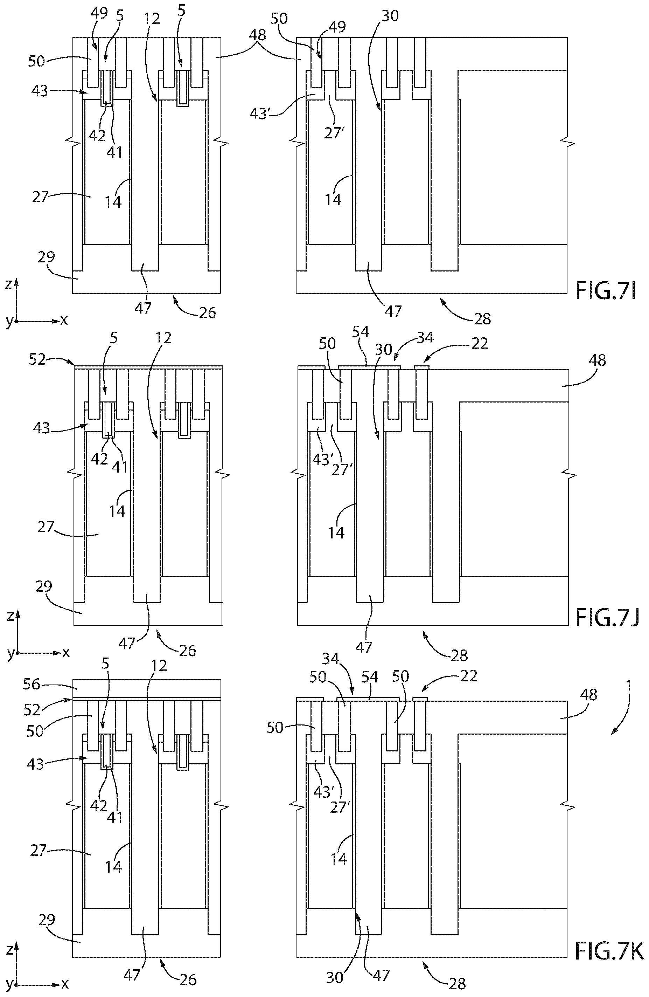

With reference first to Figure 7A, a second embodiment of the edge-termination arrangement 22 of the power semiconductor device 1 is now discussed, which differs from the one discussed above due to the absence of the shallow trenches 40 in the edge area 28.

Indeed, as shown in Figure 7A, a first step of the manufacturing process envisages formation of the shallow trenches 40 only in the active area 26, where the same shallow trenches 40 are designed to form the gate trenches for the active cells 5 of the power semiconductor device 1; no shallow trenches are instead formed in the edge area 28.

As shown in Figure 7B, the thin dielectric layer 41 is then formed, e.g. by thermal oxidation, on the top surface 27a of the epitaxial layer 27 and in the shallow trenches 40 in the active area 26 (coating lateral walls and a bottom thereof).

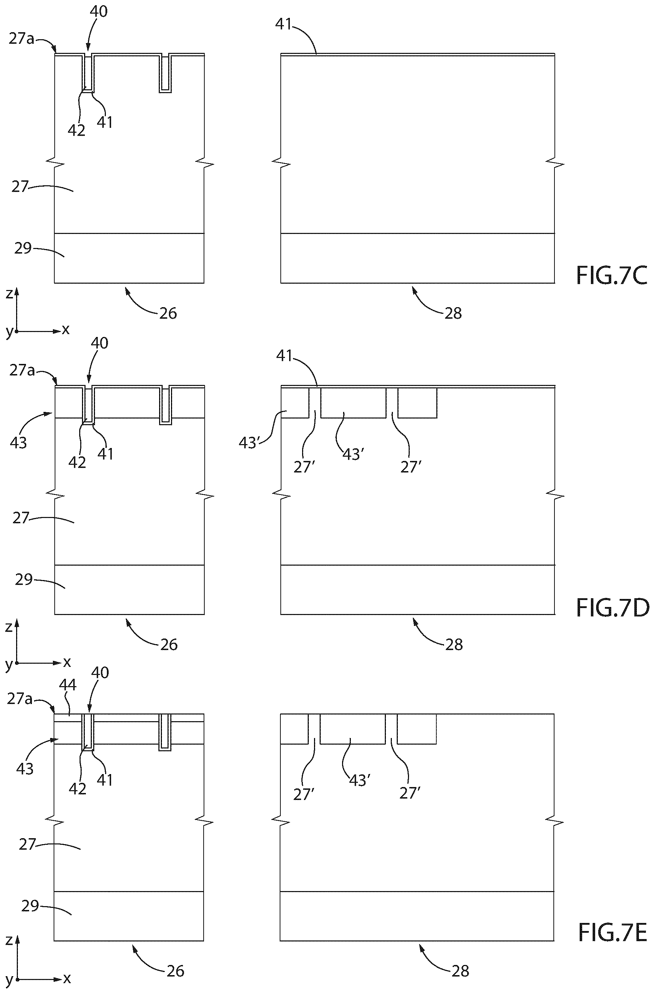

Subsequently, the doped polysilicon region 42 is formed, Figure 7C within the shallow trenches 40 in the active area 26.

As shown in Figure 7D, the doped layer 43 of the second doping type (p type) is next formed in the surface portion of the epitaxial layer 27, at the top surface 27a thereof, to form in the active area 26 body regions for the active cells 5 of the power semiconductor device 1.

In particular, the doped layer 43 is suitably patterned in the edge area 28, so as not to be present in separating portions 27' of the same epitaxial layer 27; in other words, the doped layer 43 has, in the edge area 28, respective doped regions 43' which are separated in the horizontal plane by the separating portions 27' of the epitaxial layer 27.

The manufacturing process then envisages, Figure 7E, first removal of the thin dielectric layer 41 from the top surface 27a of the epitaxial layer 27 and then, only in the active area 26 of the power semiconductor device 1, the superficial doping for the formation of the superficial doped layer 44 having the first doping type (n type), to form the source regions for the active cells 5.

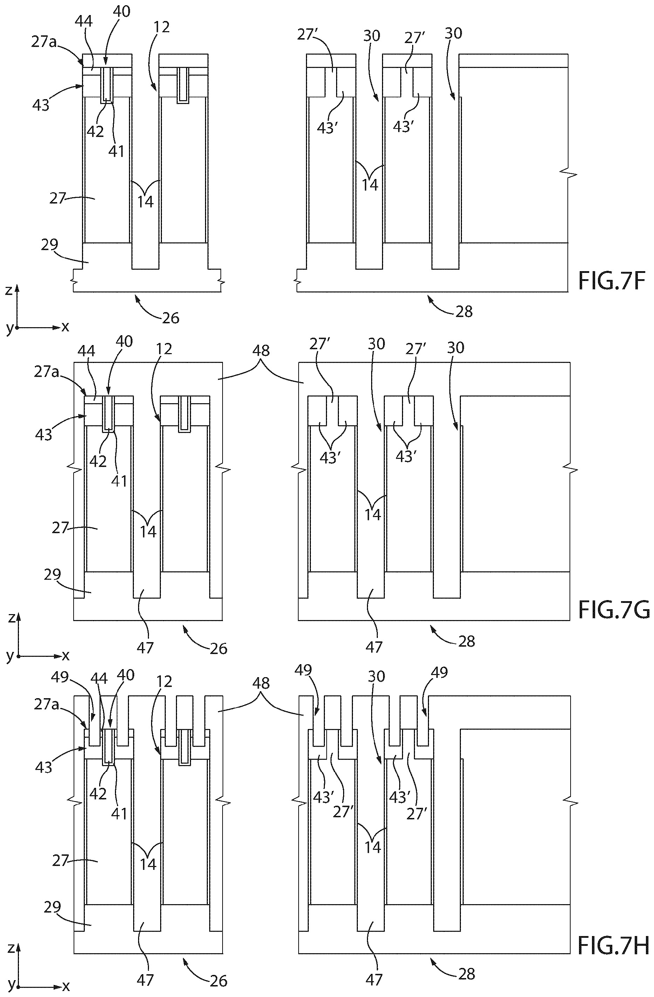

Afterwards, Figure 7F, the deep trenches are etched, through the epitaxial layer 27 and reaching the substrate 29. In the active area 26, each of the resulting charge-balancing deep trenches 12 is formed between a respective pair of shallow trenches 40; in the edge area 28, the resulting edge-termination deep trenches 30 are formed, at the doped regions 43' of the doped layer 43.

Subsequently, the sidewalls of the deep trenches 46 are doped to form the thin doped layers 14, as shown in the same Figure 7F. In particular, the thin doped layers 14 of each edge-termination deep trench 30 are continuous to respective doped regions 43' of the doped layer 43.

The manufacturing process then continues, Figure 7G, with filling of the deep trenches 46 with the dielectric filling region 47 and the formation of the dielectric layer 48 on the top surface 27a of the epitaxial layer 27.

As shown in Figure 7H, contact openings 49 are then opened through the dielectric layer 48 and the underlying doped layer 43 (and the superficial doped layer 44 in the active area 26). In particular, a pair of contact openings 49 are formed at the sides of each of the shallow trenches 40, in the active area 26; in the edge area 28, a pair of contact openings 49 are instead formed at the sides of a respective separating portion 27' of the epitaxial layer 27, reaching respective doped regions 43' of the doped layer 43.

As shown in Figure 7I, the contact opening 49 are then filled with a conductive material, e.g. Tungsten, to form the contacts (or "plugs") 50.

The thin barrier layer 52, of a conductive material, e.g. TiN, is then deposited on the dielectric layer 48, as shown in Figure 6J, contacting the contacts 50 from above.

The barrier layer 52 is continuous in the active area 26. As discussed above, the same barrier layer 52 is patterned in the edge area 28 in order to define the barrier portions 54, which are configured to electrically connect the thin doped layers 14 at the sidewalls of each of the adjacent edge-termination deep trenches 30. In particular, each barrier portion 54 contacts from above a pair of contacts 50 arranged at the sides of a respective edge-termination deep trench 30; these barrier portions 54, together with the respective contacts 50 therefore define the above-discussed electrical connection structures 34 of the edge-termination arrangement 22.

As shown in Figure 7K, the manufacturing process then continues with the formation of the thick top metal layer 56 on the barrier layer 52 in the sole active area 26, to define the source contact layer 16 of the power semiconductor device 1.

This embodiment has the advantage of not requiring formation of shallow trenches in the edge area 28. However, the previously discussed embodiment, with the polysilicon filled shallow trenches 40 arranged between the contacts 50, may allow better confinement of the electrical field lines in the edge area 28.

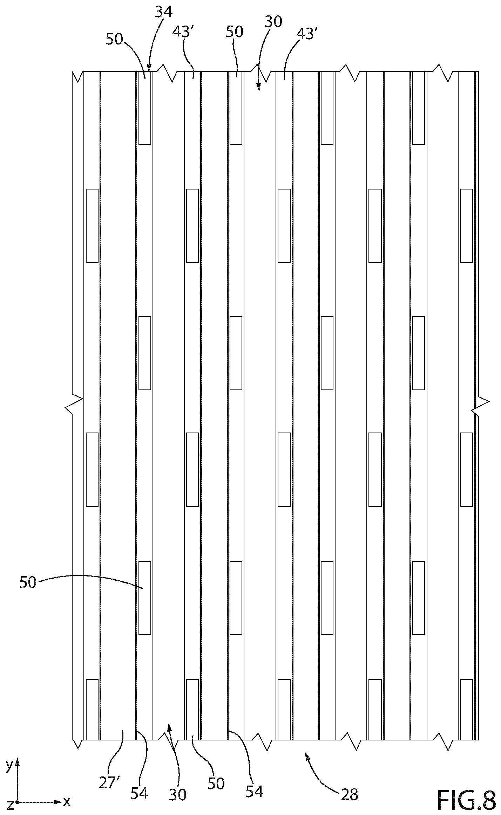

Also in this embodiment, as shown in Figure 8 (which relates to an edge portion of the power semiconductor device 1), the electrical connection structures 34 may not be continuous along the extension direction of the respective edge-termination deep trenches 30, instead being distributed regularly with a given separation distance along the same extension direction (in Figure 8, along the second axis y).

In this case, the barrier portions 54 of the connection structures 34 are continuous along the extension direction; instead, the contacts 50 (having in the example a substantially rectangular shape in the horizontal plane xy), are arranged in a localized manner, at a certain distance of separation along the same extension direction (in Figure 8, along the second axis y).

Moreover, the same contacts 50 are staggered in the extension direction, so that contacts 50 of adjacent edge-termination deep trenches 30 are not aligned (in Figure 8, along the first axis x of the horizontal plane xy). In the embodiment shown in the same Figure 8, contacts 50 of any given edge-termination deep trench 30 and of a next non-adjacent edge-termination deep trench 30 are instead aligned along the first axis x.

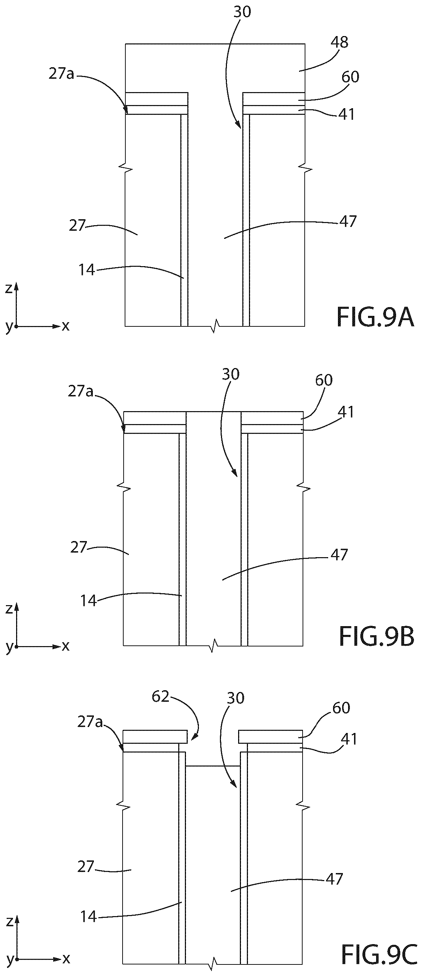

With reference first to Figure 9A, a third embodiment of the edge-termination arrangement 22 of the power semiconductor device 1 is now discussed, which envisages formation of the electrical connection structures 34 of the edge-termination arrangement 22 with a self-aligned process. The process will be discussed with specific reference to the formation of the edge-termination arrangement 22 in the edge area 28 (formation of the active cells 5 in the active area 26 will not be disclosed again).

As shown in Figure 9A, the process starts with formation of the thin dielectric layer, again denoted with 41, on the top surface 27a of the epitaxial layer 27 and, in this case, of a thin passivation layer 60, e.g. of Nitride, on the thin dielectric layer 41.

Then, the deep trenches are etched through the epitaxial layer 27 (and the thin dielectric and passivation layers 41, 60) and reaching the substrate 29 (here not shown), for the formation, in the edge area 28, of the edge-termination deep trenches 30. The sidewalls of the edge-termination deep trenches 30 are doped to form the thin doped layers 14.

Afterwards, the edge-termination deep trenches 30 are filled with the dielectric filling region 47 and the dielectric layer 48 on the top surface 27a of the epitaxial layer 27 is also formed.

As shown in Figure 9B, a planarization step is then performed (e.g. with a CMP - Chemical Mechanical Polishing), which leads to removal of the portion of the dielectric layer 48 above the thin passivation layer 60.

Afterwards, Figure 9C, etching of a surface portion of the dielectric filling region 47 is performed, leading to the formation of a contact hole 62, on top of each edge-termination deep trench 30, at the top surface 27a of the epitaxial layer 27. As shown in the same Figure 9C, etching also causes removal of part of the thin dielectric layer 41 underneath the thin passivation layer 60, laterally with respect to the contact hole 62 in the horizontal plane xy.

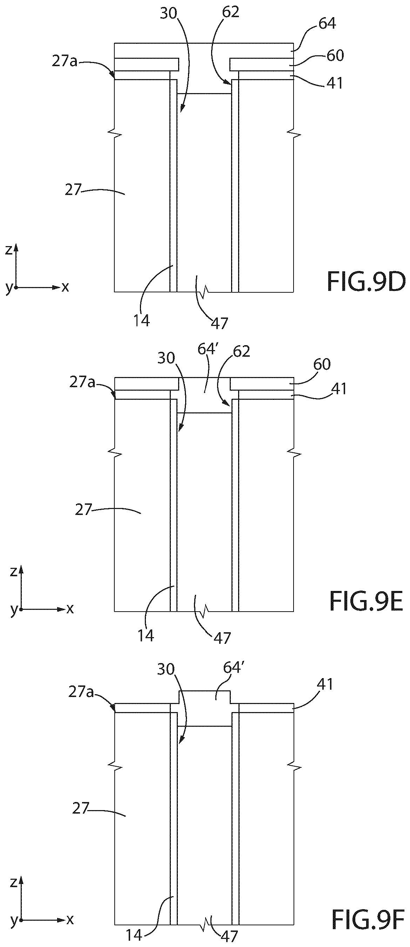

Then, as shown in Figure 9D, a step of polysilicon deposition is performed, the polysilicon being doped with the second doping type (p-type), leading to formation of a polysilicon layer 64 on the thin passivation layer 60 and within the contact holes 62 on top of the edge-termination deep trenches 30.

This polysilicon layer 64 is then recessed (e.g., with a CMP technique), as shown in Figure 9E, at the level of the thin passivation layer 60, leaving only bridging portions 64' of the same polysilicon layer 64, filling the respective contact holes 62 and thereby closing at the top the respective edge-termination deep trench 30.

These bridging portions 64' constitute here the electrical connection between the thin doped layers 14 of the respective edge-termination deep trenches 30.

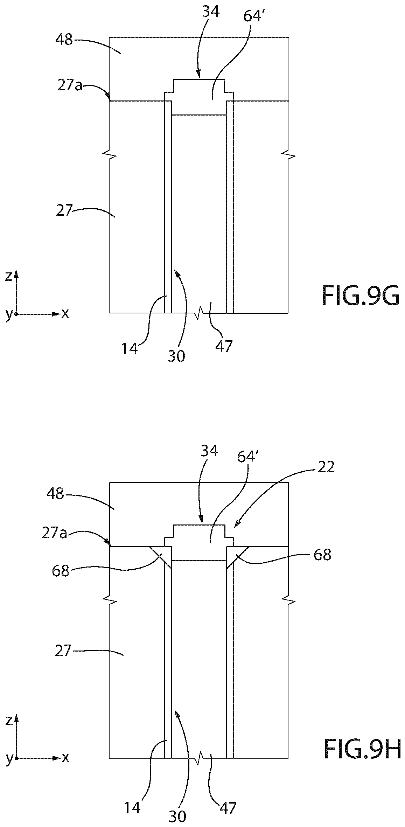

The thin passivation layer 60 is then removed, as shown in Figure 9F, and a thick dielectric layer, again denoted with 48, is formed above the top surface 27a of the epitaxial layer 27, also on the bridging portions 64', as shown in Figure 9G.

According to an aspect of the present solution, an annealing step is then performed (e.g. a RTA, Rapid Thermal Annealing), that causes, as shown in Figure 9H, lateral diffusion of dopants from the doped polysilicon of the bridging portions 64', causing formation of doped regions 68 in the epitaxial layer 27, in contact with the bridging portions 64' and with the thin doped layers 14 at the sidewall of the edge-termination deep trenches 30.

In this embodiment, therefore, the bridging portions 64' and the doped regions 68 define the above-discussed electrical connection structures 34 of the edge-termination arrangement 22.

Advantageously, the electrical connection structures 34 are in this case obtained in a self-aligned manner with respect to the thin doped layers 14 at the sidewall of the edge-termination deep trenches 30, therefore with a simplified process flow.

The advantages of the proposed solution are clear from the preceding description.

The disclosed solution provides an edge termination arrangement for a power semiconductor device (in particular of the charge-balanced super-junction type), wherein charge-balancing deep trenches in the edge area with thin doped layers at the sidewalls thereof allow a correspondent narrow and heavily doped n-type epitaxial drift region that improve the trade-off between on-resistance and breakdown voltage.

In particular, these thin doped layers are shorted with a proper connection structure, so as to keep the charge-balancing deep trenches at a floating potential, allowing to distribute the potential at the edge area, avoiding equipotential lines escaping near the surface of the epitaxial layer.

Finally, it is clear that modifications and variations may be made to what has been described and illustrated herein without thereby departing from the scope of the present invention, as defined in the attached claims.

In particular, it is underlined that the discussed solution may be applied to different types of power semiconductor devices, such as power diodes or JFETs.

Moreover, it may be envisaged not to provide an electrical connection structure 34 for the last of the edge-termination deep trenches 30 (i.e., the one at a highest distance from the active area 26), since this last deep trench can sustain a certain amount of potential drop with a reduced effect on the termination balance.

## Claims

1. A superjunction power semiconductor device (1) having a die (20') of semiconductor material comprising a substrate (29) and a structural layer (27) formed on the substrate (29) and having a first doping type,
wherein the die (20') has an active area (26) where active cells (5) are formed and an edge area (28) surrounding the active area (26) at the periphery of the die (20') and comprises, in the active area (26), a plurality of charge-balancing deep trenches (12) filled with dielectric, extending between respective pairs of active cells (5) throughout the structural layer (27) and reaching the substrate (29), each charge-balancing deep trench (12) having doped layers (14) with a second doping type at sidewalls thereof,
further comprising an edge termination arrangement (22) at the edge area (28) including a plurality of edge-termination trenches (30), extending through the structural layer (27) and reaching the substrate (29), filled with dielectric and having respective doped layers (14) having a second doping type at sidewalls thereof;
wherein the edge termination arrangement (22) comprises electrical connection structures (34), configured to electrically connect together the respective doped layers (14) at the sidewalls of the edge-termination trenches (30).

2. The device of claim 1, wherein a first one of the electrical connection structures (34), nearest to the active area (26), is electrically connected to a last active cell (5) in the active area (26) and all other electrical connection structures (34) are at a floating potential.

3. The device of claim 1 or 2, wherein the electrical connection structures (34) comprise respective bridging conductive portions (54; 64'), each arranged above and across a respective edge-termination trench (30) and electrically shorting the respective doped layers (14) at the sidewalls of the respective edge-termination trench (30).

4. The device of any of the preceding claims, comprising a dielectric layer (48) on a top surface (27a) of the structural layer (27); wherein each of the electrical connection structures (34) comprises: a pair of contacts (50) arranged at the sides of a respective edge-termination trench (30), traversing the dielectric layer (48) and designed to electrically contact a respective doped layer (14); and a barrier portion (54) arranged on the dielectric layer (48) and contacting from above the pair of contacts (50).

5. The device of claim 4, wherein the edge termination arrangement (22) comprises doped regions (43') at the top surface (27a) of the structural layer (27) and having a same doping type as the doped layers (14), arranged laterally to the edge-termination trenches (30) to contact the respective doped layers (14); wherein the contacts (50) are configured to reach the doped regions (43') in the structural layer (27).

6. The device of claim 4 or 5, wherein the edge termination arrangement (22) comprises shallow trenches (40) in the structural layer (27) at the top surface (27a) thereof, arranged between the contacts (50) and including a polysilicon region (42) separated from the doped regions (43') by a dielectric layer (41).

7. The device of claim 6, wherein the electrical connection structures (34) moreover comprise: further contacts (50') traversing the dielectric layer (48) and configured to electrically contact the polysilicon regions (42) of respective shallow trenches (40); wherein the barrier portions (54) of the electrical connection structures (34) are configured to contact from above also the respective further contacts (50').

8. The device of claim 5, wherein the doped regions (43') are separated by separating portions (27') of the epitaxial layer (27), arranged between the contacts (50).

9. The device of any of claims 1-3, wherein the electrical connection structures (34) comprise conductive bridging portions (64') arranged at a top surface (27a) of the structural layer (27) and closing at the top respective edge-termination trenches (30); and doped regions (68) in the structural layer (27), in contact with the bridging portions (64') and with the thin doped layers (14) at the sidewalls of the respective edge-termination trenches (30).

10. The device of any of the preceding claims, wherein the electrical connection structures (34) are not continuous along an extension direction of the respective edge-termination deep trenches (30), being distributed regularly with a given separation distance along said extension direction.

11. The device of any of the preceding claims, wherein the superjunction power semiconductor device (1) is a trench-gate power MOSFET device.

12. A process for manufacturing a superjunction power semiconductor device (1), comprising forming in a die (20') of semiconductor material, having a substrate (29) and a structural layer (27) on the substrate (29) with a first doping type, an active area (26) with active cells (5) and an edge area (28) surrounding the active area (26) at the periphery of the die (20'),
forming the active area (26) comprising forming a plurality of charge-balancing deep trenches (12) filled with dielectric, extending between respective pairs of active cells (5) throughout the structural layer (27) and reaching the substrate (29), each charge-balancing deep trench (12) having doped layers (14) with a second doping type at sidewalls thereof,
comprising forming an edge termination arrangement (22) at the edge area (28) with a plurality of edge-termination trenches (30) extending through the structural layer (27) and reaching the substrate (29), filled with a dielectric material and having respective doped layers (14) having a second doping type at sidewalls thereof;
wherein forming the edge termination arrangement (22) comprises forming electrical connection structures (34), configured to electrically connect together the respective doped layers (14) at the sidewalls of the edge-termination trenches (30).

13. The process according to claim 12, wherein forming the electrical connection structures (34) comprises forming bridging conductive portions (54; 64'), each arranged above and across a respective edge-termination trench (30) and electrically shorting the respective doped layers (14).

14. The process according to claim 13, comprising forming a dielectric layer (48) on a top surface (27a) of the structural layer (27); wherein forming the electrical connection structures (34) comprises forming a pair of contacts (50) arranged at the sides of a respective edge-termination trench (30), traversing the dielectric layer (48) and designed to electrically contact a respective doped layer (14) of the respective edge-termination trench (30); and a barrier portion (54) arranged on the dielectric layer (48) and contacting from above the pair of contacts (50).

15. The process of claim 14, comprising, before the formation of the edge-termination trenches (30): forming shallow trenches (40) in the structural layer (27) at the top surface (27a) thereof, including a polysilicon region (42) separated from the epitaxial layer (27) by a dielectric layer (41); and forming a doped layer (43) in a surface portion of the epitaxial layer (27), at the top surface (27a); wherein forming the electrical connection structures (34) comprises: forming a pair of contact openings (49) through the dielectric layer (48) and the underlying doped layer (43) at the sides of each of the shallow trenches (40); filling the contact openings (49) with a conductive material to form the contacts (50); and patterning a barrier layer (52), of a conductive material, deposited on the dielectric layer (48), to define the barrier portions (54).

16. The process of claim 15, wherein forming the electrical connection structures (34) moreover comprise: forming further contacts (50') traversing the dielectric layer (48) to electrically contact the polysilicon regions (42) of respective shallow trenches (40); wherein the barrier portions (54) of the electrical connection structures (34) are configured to contact from above also the respective further contacts (50').

17. The process of claim 14, comprising, before the formation of the edge-termination trenches (30): patterning a doped layer (43) in a surface portion of the epitaxial layer (27), at the top surface (27a), so as to define doped regions (43') separated by separating portions (27') of the epitaxial layer (27); wherein the edge-termination trenches (30) are formed at the doped regions (43') of the doped layer (43); and wherein forming the electrical connection structures (34) comprises: forming a pair of contact openings (49) at the sides of a respective separating portion (27') of the epitaxial layer (27), reaching respective doped regions (43') of the doped layer (43); filling the contact openings (49) with a conductive material to define the contacts (50); and patterning a barrier layer (52), of a conductive material, deposited on the dielectric layer (48), to define the barrier portions (54).

18. The process of claim 13, wherein forming the electrical connection structures (34) comprises: forming contact holes (62), on top of the edge-termination trenches (30), at the top surface (27a) of the epitaxial layer (27); depositing and patterning a doped polysilicon layer (64) to form bridging portions (64') within the contact holes (62) closing at the top the edge-termination trenches (30); performing an annealing step causing lateral diffusion of dopants from the doped polysilicon of the bridging portions (64') and formation of doped regions (68) in the structural layer (27), in contact with the bridging portions (64') and with the thin doped layers (14) at the sidewalls of the respective edge-termination trenches (30).
